(19) Europäisches Patentamt / European Patent Office / Office européen des brevets

(11) **EP 4 489 301 A1**

(12) **DEMANDE DE BREVET EUROPEEN**

(43) Date de publication:
**08.01.2025 Bulletin 2025/02**

(21) Numéro de dépôt: **24187200.1**

(22) Date de dépôt: **08.07.2024**

(51) Classification Internationale des Brevets (IPC):
**H03F 1/02** *(2006.01)*　　**H03F 1/56** *(2006.01)*
**H03F 1/22** *(2006.01)*　　**H03F 3/195** *(2006.01)*
**H03F 3/24** *(2006.01)*　　**H03F 3/72** *(2006.01)*

(52) Classification Coopérative des Brevets (CPC):
**H03F 1/0288; H03F 1/223; H03F 1/565;**
**H03F 3/195; H03F 3/245; H03F 3/72;**
H03F 2200/111; H03F 2200/222; H03F 2200/318;
H03F 2200/387; H03F 2200/39; H03F 2200/429;
H03F 2200/451; H03F 2203/7209

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **07.07.2023 FR 2307281**

(71) Demandeur: **Commissariat à l'Energie Atomique et aux Energies Alternatives 75015 Paris (FR)**

(72) Inventeurs:
• **SERHAN, Ayssar**
 **38054 GRENOBLE Cedex 09 (FR)**
• **REYNIER, Pascal**
 **38054 GRENOBLE Cedex 09 (FR)**
• **GIRY, Alexandre**
 **38054 GRENOBLE Cedex 09 (FR)**

(74) Mandataire: **Atout PI Laplace Immeuble Up On 25 Boulevard Romain Rolland CS 40072 75685 Paris Cedex 14 (FR)**

(54) **AMPLIFICATEUR DE PUISSANCE DOHERTY MULTI-BANDES**

(57) L'invention se rapporte à un amplificateur Doherty comprenant :
- un port d'entrée ;
- un étage de pré-amplification ;
- au moins un port de sortie ;
caractérisé en ce que l'amplificateur Doherty comprend en outre :
- une voie d'amplification bande haute ;
- une voie d'amplification bande basse ;
la voie d'amplification bande haute (VA$_{HB}$) et la voie d'amplification bande basse comprenant chacune un amplificateur principal, un amplificateur auxiliaire, et un réseau d'adaptation d'impédance de sortie ;
- un réseau commun connecté à la voie d'amplification bande haute et à la voie d'amplification bande basse, le réseau commun comprenant un commutateur configuré pour activer sélectivement la voie d'amplification bande haute ou la voie d'amplification bande basse ;
dans lequel un réseau intermédiaire d'adaptation d'impédance est réparti entre le réseau commun, la voie d'amplification bande haute et la voie d'amplification bande basse.

[Fig. 1]

**Fig. 1**

EP 4 489 301 A1

**Description**

**Domaine technique**

La présente invention se rapporte à un amplificateur de puissance Doherty multi-bandes. L'invention est applicable en particulier aux équipements de télécommunications utilisables dans les réseaux de téléphonie mobile ou dans les réseaux WiFi.

Les standards de communication modernes du type 4G/5G/6G et WiFi6/6E/7 augmentent considérablement la complexité des modules frontaux RF, dont l'amplificateur de puissance représente une partie critique, en termes de taille et de consommation d'énergie.

En effet, le besoin d'une consommation d'énergie réduite avec une taille et un coût de fabrication réduits, pousse la recherche vers des amplificateurs de puissance multi-bandes à haut rendement et à haut niveau d'intégration, avec de fortes exigences de linéarité.

Les signaux utilisés dans les standards 4G/5G/6G et Wifi6/6E/7 ont des rapports de puissance crête à puissance moyenne (PAPR pour « Peak-to-Average Power Ratio ») élevés (supérieur à 4 dB), en raison, notamment, de la présence d'un grand nombre de sous-porteuses modulées dans ces systèmes de communication de type OFDM.

Avec un PAPR élevé, il est d'autant plus nécessaire d'abaisser le niveau de puissance de l'amplificateur de puissance par rapport à la puissance crête (« back-off » selon la terminologie anglo-saxonne), afin de répondre à des spécifications de linéarité strictes.

Plus précisément, le « back-off » de puissance est un niveau de puissance inférieur au point de saturation qui permet de faire fonctionner l'amplificateur dans une zone linéaire. Habituellement, les amplificateurs de puissance fonctionnent près du point de saturation car c'est là que l'efficacité est maximale. Pour s'assurer que l'amplificateur fonctionne dans la zone linéaire, le niveau de puissance est abaissé à partir du point d'efficacité maximale. Le niveau de réduction de puissance est appelé « Power Back-off » (ou « back-off » de puissance).

Dans les amplificateurs de puissance de l'état de l'art, la réduction de puissance dégrade considérablement l'efficacité moyenne de l'amplificateur de puissance. Ainsi, outre le fait que l'amplificateur de puissance doive conserver une efficacité élevée malgré le back-off de puissance, l'amplificateur de puissance doit également être à large bande ou multi-bandes afin de prendre en charge un nombre accru de bandes de fréquences.

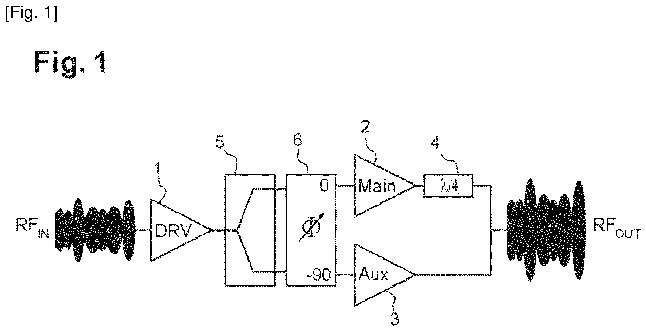

L'amplificateur de puissance Doherty représente une solution intéressante pour une amplification efficace des signaux à PAPR élevés. Le principe de fonctionnement de l'amplificateur Doherty est illustré par la figure 1, et plus en détails dans [1]. Le signal d'entrée $RF_{IN}$ est pré-amplifié par un étage de pré-amplification 1, et le signal est séparé par un diviseur de puissance 5. L'amplificateur Doherty comprend un amplificateur principal 2, un amplificateur auxiliaire 3, un circuit d'adaptation d'impédance 6 en entrée de l'amplificateur principal 2 et de l'amplificateur auxiliaire 3, et un circuit d'adaptation d'impédance en sortie 4 comprenant une ligne quart d'onde jouant ici le rôle d'inverseur d'impédance. Il est possible de considérer d'autres types de combineurs qui n'utilisent pas forcément de ligne quart d'onde. Le circuit d'adaptation d'impédance 6 applique une compensation de phase prédéterminée entre la chaîne principale et la chaîne auxiliaire. Un réseau d'adaptation en sortie (non représenté) permet éventuellement de transformer l'impédance de charge du système (classiquement 50 Ohm) en une impédance optimale de fonctionnement.

L'amplificateur de puissance Doherty utilise le concept de modulation de charge active (ou dynamique), dans lequel la charge vue par l'amplificateur principal 2 est modulée en injectant un courant à partir de l'amplificateur auxiliaire 3. L'amplificateur principal 2, fonctionnant classiquement en classe AB, est toujours actif, tandis que l'amplificateur auxiliaire 3, fonctionnant classiquement en classe C ou AB profonde, ne contribue que dans la région de backoff.

Les amplificateurs de puissance Doherty ont généralement une bande de fonctionnement optimale limitée (bande fractionnaire FBW < 10%) et nécessitent un contrôle de phase précis au niveau du circuit d'adaptation d'impédance 6 pour maintenir des performances (efficacité et linéarité) élevées sur la bande de fréquence visée.

La bande fractionnaire de fonctionnement est donnée par la relation suivante :

$$FBW=(Fmax-Fmin)/Fcentral$$

Avec Fmin la fréquence minimum de la bande de fonctionnement, Fmax la fréquence maximum de la bande de fonctionnement, et Fcentral la fréquence centrale.

Pour surmonter la dégradation des performances des amplificateurs de puissance Doherty sur une gamme de fréquences élevée, des architectures d'amplificateurs de puissance Doherty accordables ont été récemment introduites.

Dans [2], une architecture d'amplificateur de puissance Doherty ayant une bande de fréquences élargie (1,55 - 2,3 GHz) comprend plusieurs condensateurs accordables. L'amplificateur nécessite l'utilisation d'une technique de pré-distorsion numérique (externe), afin de maintenir le niveau de linéarité requis sur toute la bande de fréquence, ce qui nuit à l'efficacité énergétique du système.

Dans [3], une architecture alternative d'amplificateur de puissance Doherty a un comportement linéaire sur la bande 1,9 GHz - 2,7 GHz sans nécessiter de technique de pré-distorsion numérique. L'amplificateur comprend des condensateurs accordables intégrés sur SOI-CMOS, ce qui améliore la linéarité en fréquence. Cependant, la bande de fonctionnement FBW reste inférieure à 25 %.

Il existe donc un besoin pour fournir un amplificateur de puissance Doherty linéaire ayant une bande de fonctionnement fractionnaire FBW améliorée, et n'utilisant pas de technique de pré-distorsion numérique.

## Résumé de l'invention

Un objet de l'invention est donc un amplificateur Doherty tel que défini selon les revendications 1 à 5.

## Description des figures

D'autres caractéristiques, détails et avantages de l'invention ressortiront à la lecture de la description faite en référence aux dessins annexés donnés à titre d'exemple.

La figure 1, déjà décrite, illustre le principe de fonctionnement d'un amplificateur de puissance Doherty.

La figure 2a et la figure 2b illustrent des vues en détail d'un circuit d'amplificateur de puissance Doherty selon l'invention, et la figure 2c illustre une variante de la figure 2b.

La figure 3 illustre différentes performances obtenues avec le circuit d'amplificateur de puissance Doherty selon l'invention.

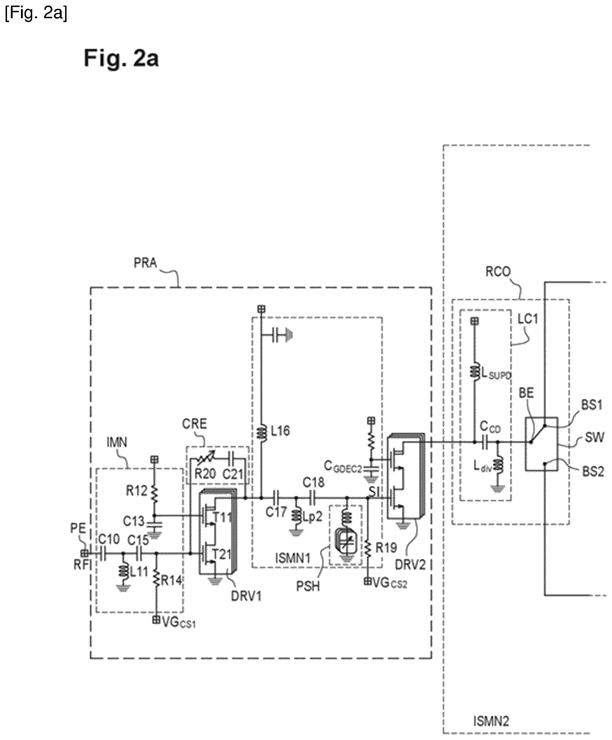

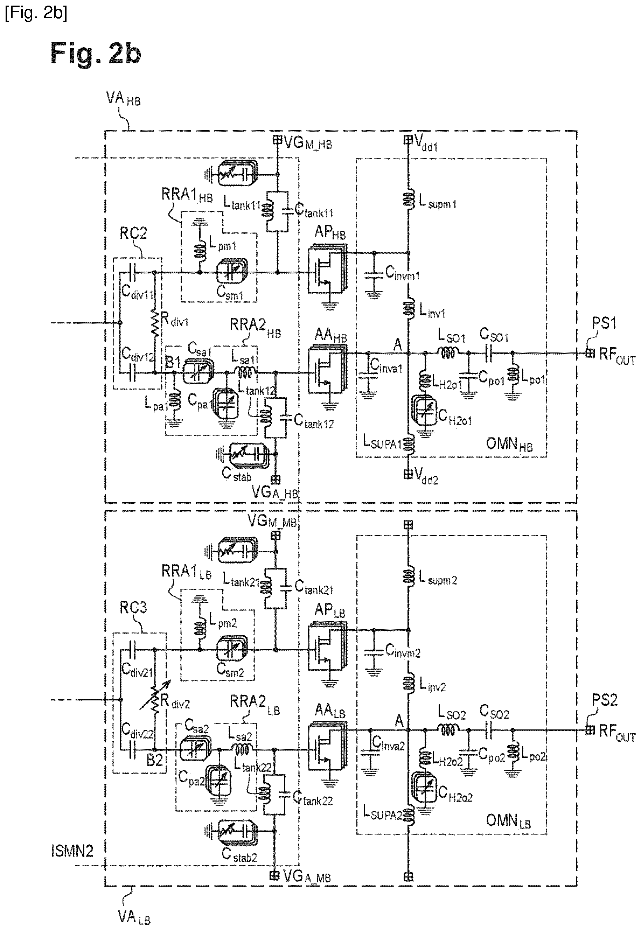

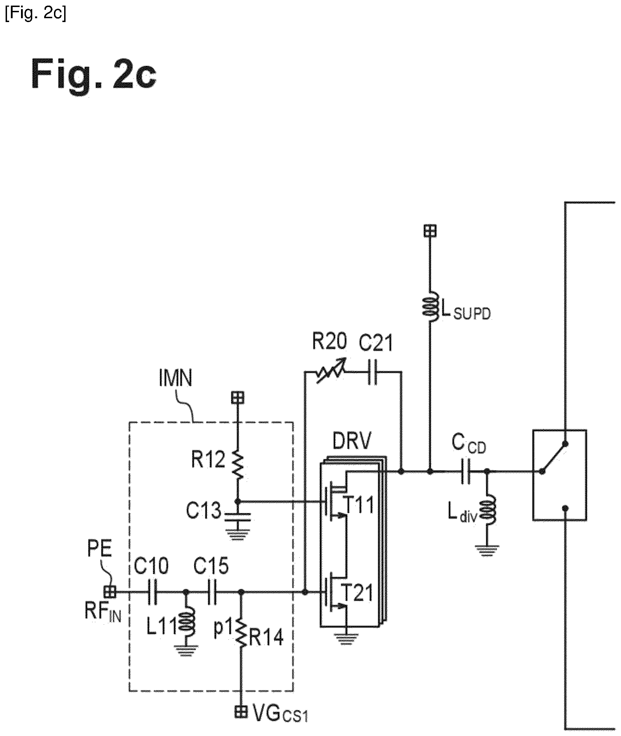

L'amplificateur Doherty selon l'invention est illustré par les figures 2a, 2b et 2c.

Le port d'entrée PE reçoit le signal RF d'entrée $RF_{IN}$ à amplifier. Un étage de de pré-amplification PRA permet d'amplifier le signal RF d'entrée $RF_{IN}$, de façon à générer un signal intermédiaire SI, pour augmenter le gain global de l'amplificateur Doherty.

Un réseau commun RCO, qui comprend un commutateur SW, est connecté en sortie de l'étage de pré-amplification PRA. Le réseau commun RCO est également connecté à une voie d'amplification bande haute $VA_{HB}$ et à une voie d'amplification bande basse $VA_{LB}$. Le commutateur SW peut activer sélectivement la voie d'amplification bande haute $VA_{HB}$ ou la voie d'amplification bande basse $VA_{LB}$ en fonction de la fréquence porteuse du signal RF d'entrée. L'amplificateur Doherty comprend également des moyens externes de réglage des signaux de polarisation pour les transistors selon que la voie d'amplification bande haute $VA_{HB}$ ou la voie d'amplification bande basse $VA_{LB}$ soit sélectionnée.

A cet effet, le commutateur SW comprend une borne d'entrée BE, connectée à l'étage de pré-amplification PRA, et deux bornes de sortie. Une borne de sortie BS1 est connectée à la voie d'amplification bande haute $VA_{HB}$, et une borne de sortie BS2 est connectée à la voie d'amplification bande basse $VA_{LB}$. Un exemple de commutateur utilisable est un interrupteur de type SPDT (pour « Single Pole Double Throw ») à une entrée et deux sortie.

La sélection de l'une ou l'autre des voies d'amplification de l'amplificateur Doherty est effectuée automatiquement en fonction de la connaissance de la fréquence porteuse du signal à amplifier.

Par exemple, la commutation entre les voies d'amplification peut être effectuée de façon dynamique, c'est-à-dire en cours d'utilisation de l'amplificateur Doherty. Selon un autre mode de réalisation, l'amplificateur Doherty, intégré dans un équipement de télécommunications (par exemple une station de base ou un terminal utilisateur), peut commander la commutation entre les voies d'amplification en fonction du déplacement de l'utilisateur et/ou du changement de cellule de l'utilisateur.

La commutation d'une voie d'amplification à l'autre peut être commandée par un dispositif de commande (non représenté sur les figures).

La voie d'amplification bande haute $VA_{HB}$ est adaptée pour amplifier le signal intermédiaire dont la bande de fréquence de fonctionnement se trouve dans une bande de fréquences dite supérieure. Selon le principe de fonctionnement de l'amplificateur Doherty rappelé précédemment, la voie d'amplification bande haute $VA_{HB}$ comprend un amplificateur principal $AP_{HB}$ fonctionnant en classe AB, et un amplificateur auxiliaire $AA_{HB}$ fonctionnant en classe C ou AB profonde. Par ailleurs, la voie d'amplification bande haute $VA_{HB}$ comprend un réseau d'adaptation d'impédance de sortie $OMN_{HB}$ connecté à l'amplificateur principal $AP_{HB}$, à l'amplificateur auxiliaire $AA_{HB}$, et au port de sortie PS1 au niveau duquel le signal amplifié est prélevé. La recombinaison des signaux issus des amplificateurs principal et auxiliaire a lieu au niveau du noeud A.

L'amplificateur principal/auxiliaire peut être constitué d'un transistor (transistor de type LDMOS sur les figures 2a et 2b mais un autre type de transistor peut être utilisé), d'un empilement de transistors (cas des étages de drivers, mais cela pourrait également être le cas pour l'étage de sortie), ou d'une combinaison de transistors.

De façon avantageuse, l'amplificateur principal et l'amplificateur auxiliaire de chaque voie comprennent des transistors de type LDMOS (« laterally-diffused metal-oxide semiconductor »), qui offrent une tension de claquage élevée (supérieure à 10 Volts), ce qui est nécessaire pour des applications nécessitant de fortes puissances de sortie (> 1W) telles que les téléphones mobiles ou les stations de base de télécommunications. D'autres technologies peuvent être envisagées pour les transistors de l'étage de puissance, notamment des transistors empilés de type MOS+MOS ou MOS+LDMOS, des transistors BiCMOS ou encore GaAs, GaN ou InP.

Selon un mode de réalisation, la sortie de l'amplificateur principal $AP_{HB}$ (drain du transistor) est connectée à la sortie de l'amplificateur auxiliaire $AA_{HB}$ (drain du transistor) par le biais d'un inverseur d'impédance de type réseau en pi à éléments localisés équivalent à une ligne quart d'onde. L'inverseur d'impédance est composé d'un condensateur $C_{invm1}$ connecté entre la sortie de l'amplificateur principal $AP_{HB}$ et la masse, d'un condensateur $C_{inva1}$ connecté entre la sortie de l'amplificateur auxiliaire $AA_{HB}$ et la masse, et d'une bobine $L_{inv1}$ reliant les deux sorties de l'amplificateur principal $AP_{HB}$ et de l'amplificateur auxiliaire $AA_{HB}$.

Le combineur de sortie peut adopter une topologie différente, telle qu'une topologie décrite dans [4].

Les condensateurs $C_{invm1}$ et $C_{inva1}$, et la bobine $L_{inv1}$ sont dimensionnés de façon à ce que l'impédance caractéristique $Z_c$ de l'inverseur d'impédance soit égale à $Z_c = 2 \times Z_{opt}$, avec $Z_{opt}$ l'impédance de charge optimale au noeud A qui correspond à la sortie de l'amplificateur auxiliaire $AA_{HB}$.

Le réseau de sortie $OMN_{HB}$ comprend une bobine $L_{SUPM1}$ connectée entre la source de tension d'alimentation externe $V_{dd}$ de l'amplificateur principal $AP_{HB}$ et la sortie de l'amplificateur principal $AP_{HB}$ De même, une bobine $L_{SUPA1}$ est connectée entre la source de tension d'alimentation externe $V_{dd2}$ de l'amplificateur auxiliaire $AA_{HB}$ et le noeud A.

Un réseau résonant réglable, composé d'une bobine $L_{H2o1}$ et d'un condensateur variable $C_{H2o1}$, est connecté entre le noeud A et la masse. Ce réseau résonant, constitue une terminaison harmonique réglable qui est utilisée pour améliorer la réjection de la deuxième harmonique par rapport à la fréquence fondamentale.

Le filtre LC composé d'une bobine $L_{SO1}$, d'un condensateur $C_{SO1}$, du condensateur $C_{po1}$ et de la bobine $L_{po1}$, fait partie du réseau d'adaptation de sortie à la fréquence fondamentale.

La voie d'amplification bande basse $VA_{LB}$ est adaptée pour amplifier le signal intermédiaire dont la bande de fréquence de fonctionnement se trouve dans une bande de fréquences dite inférieure. Elle comprend un réseau d'adaptation d'impédance de sortie de la voie d'amplification bande basse $OMN_{LB}$ qui peut être identique (mais non nécessairement) au réseau d'adaptation d'impédance de sortie de la voie d'amplification bande haute $OMN_{HB}$, le dimensionnement des composants pouvant être différent d'une voie à l'autre.

L'amplificateur Doherty comprend un port de sortie PS1 pour la voie d'amplification bande haute $VA_{HB}$ et un port de sortie PS2 pour la voie d'amplification bande basse $VA_{LB}$. Le port de sortie PS1 de la voie d'amplification bande haute $VA_{HB}$ peut être connecté à une antenne ou à un commutateur de sélection d'antenne, et le port de sortie PS2 de la voie d'amplification bande basse $VA_{LB}$ peut être connecté à une antenne différente ou à un commutateur de sélection d'antenne.

La bande de fréquences supérieure et la bande de fréquence inférieure sont de préférence disjointes. Par exemple, les composants de la voie d'amplification bande haute $VA_{HB}$ peuvent être dimensionnés pour amplifier le signal d'entrée dans la bande de fonctionnement 2,1-2,7 GHz, tandis que les composants de la voie d'amplification bande basse $VA_{LB}$ peuvent être dimensionnés pour amplifier le signal d'entrée dans la bande de fonctionnement 1,7-2,1 GHz.

L'amplificateur Doherty selon l'invention comprend un réseau intermédiaire d'adaptation d'impédance ISMN2, connecté entre l'étage de pré-amplification PRA et chacun des amplificateurs principaux ($AP_{HB}$, $AP_{LB}$) et auxiliaires ($AA_{HB}$, $AA_{LB}$). Le réseau intermédiaire d'adaptation d'impédance ISMN2 permet de présenter une impédance optimale de source à chacun des amplificateurs. Il est avantageusement réparti entre le réseau commun RCO, la voie d'amplification bande haute $VA_{HB}$ et la voie d'amplification bande basse $VA_{LB}$. Ainsi, certains des composants du réseau intermédiaire d'adaptation d'impédance ISMN2 font partie du réseau commun RCO, tandis que d'autres composants du réseau intermédiaire d'adaptation d'impédance ISMN2 font partie de la voie d'amplification bande haute $VA_{HB}$ et de la voie d'amplification bande basse $VA_{LB}$.

La conception du réseau intermédiaire d'adaptation d'impédance ISMN2 représente un aspect critique afin d'obtenir de bonnes performances RF pour l'amplificateur Doherty. En effet, il doit présenter à la fois une impédance de source optimale pour les étages de sortie et une impédance de charge optimale pour l'étage de pré-amplification.

Le fait qu'une partie des composants du réseau intermédiaire d'adaptation d'impédance ISMN2 fasse partie du réseau commun RCO, entre l'étage de pré-amplification PRA et le commutateur SW, permet de réduire la taille de la puce sur laquelle est gravée l'amplificateur Doherty.

Ainsi, l'étage diviseur de puissance, qui permet de répartir la puissance du signal entre l'amplificateur principal $AP_{HB}$ et l'amplificateur auxiliaire $AA_{HB}$, comprend un premier circuit résonant LC1 disposé dans le réseau commun RCO, un deuxième circuit résonant RC2 disposé dans la voie d'amplification bande haute $VA_{HB}$, et un troisième circuit résonant RC3 disposé dans la voie d'amplification bande basse $VA_{LB}$.

Le premier circuit résonant LC1 comprend un condensateur $C_{CD}$ connecté entre la sortie de l'étage de pré-amplification PRA et la borne d'entrée du commutateur SW, et une inductance $L_{div}$ connectée entre la borne d'entrée du commutateur SW et la masse.

Le deuxième circuit résonant RC2 comprend deux condensateurs ($C_{div11}$, $C_{div12}$) connectés en parallèle à travers la résistance $R_{div1}$. Les deux condensateurs sont connectés à la borne de sortie du commutateur SW qui active la voie d'amplification bande haute $VA_{HB}$. Le condensateur $C_{div11}$ est sur la branche de l'amplificateur principal $AP_{HB}$, et le condensateur $C_{div12}$ est sur la branche de l'amplificateur auxiliaire $AA_{HB}$. Une inductance $L_{pa1}$ est connectée entre le condensateur $C_{div12}$ et la masse. La résistance $R_{div1}$ relie les condensateurs ($C_{div11}$, $C_{div12}$) connectés en parallèle. La résistance $R_{div1}$ peut être une résistance variable, afin d'ajuster l'amplitude et la phase sur la voie d'amplification bande haute $VA_{HB}$.

L'inductance partagée $L_{div}$ forme ainsi un diviseur de Wilkinson modifié avec les condensateurs $C_{div11}$ et $C_{div12}$ et la résistance $R_{div1}$ lorsque la voie d'amplification bande haute $VA_{HB}$ est activée et avec les condensateurs $C_{div21}$ et $C_{div22}$, et la résistance $R_{div2}$ lorsque la voie d'amplification bande basse $VA_{LB}$ est activée.

Le troisième circuit résonant RC3 comprend deux condensateurs ($C_{div21}$, $C_{div22}$) connectés en parallèle à travers la résistance $R_{div2}$. Les deux condensateurs sont connectés à la borne de sortie du commutateur SW qui active la voie d'amplification bande basse $VA_{LB}$. La résistance $R_{div2}$ relie les condensateurs ($C_{div21}$, $C_{div22}$) connectés en parallèle.

Selon un mode de réalisation de l'invention, dans la voie d'amplification bande haute $VA_{HB}$, un premier réseau résonant accordable $RRA1_{HB}$ est connecté à la grille de l'amplificateur principal $AP_{HB}$ et configuré pour introduire un premier déphasage prédéfini $\Phi_m$. A cet effet, le premier réseau résonant accordable $RRA1_{HB}$ comprend une inductance $L_{pm1}$, connectée entre le deuxième circuit résonant RC2 et la masse, et un condensateur variable $C_{sm1}$ connecté entre le deuxième circuit résonant RLC2 et la grille de l'amplificateur principal $AP_{HB}$.

De même, dans la voie d'amplification bande haute $VA_{HB}$, un deuxième réseau résonant accordable $RRA2_{HB}$ est connecté à la grille de l'amplificateur auxiliaire $AA_{HB}$ et configuré pour introduire un deuxième déphasage prédéfini $\Phi_a$. A cet effet, le deuxième réseau résonant accordable $RRA2_{LB}$ comprend une inductance $L_{pa1}$, connectée entre un noeud B1 et la masse. Le noeud B1 connecte le deuxième circuit résonant RC2 à la grille de l'amplificateur auxiliaire $AA_{HB}$ par l'intermédiaire d'un condensateur variable $C_{sa1}$ mis en série avec une inductance $L_{sa1}$. Un condensateur $C_{pa1}$ est connecté entre un point intermédiaire situé entre le condensateur variable $C_{sa1}$ et l'inductance $L_{sa1}$, et la masse.

Le premier réseau résonant accordable $RRA1_{HB}$ est dimensionné et réglé de façon à ce qu'il présente l'impédance de source optimale à l'amplificateur principal $AP_{HB}$ tout en introduisant le premier déphasage prédéfini $\Phi_m$. De même, le deuxième réseau résonant accordable $RRA2_{HB}$ est dimensionné et réglé de façon à ce qu'il présente l'impédance de source optimale à l'amplificateur auxiliaire $AP_{LB}$ tout en introduisant le deuxième déphasage prédéfini $\Phi_a$.

Dans la voie d'amplification bande basse $VA_{LB}$, un premier réseau résonant accordable $RRA1_{LB}$ est identique au premier réseau résonant $RRA1_{HB}$ de la voie d'amplification bande haute $VA_{HB}$. Le premier réseau résonant accordable $RRA1_{LB}$ introduit un premier déphasage prédéfini $\Phi_m$.

Dans la voie d'amplification bande basse $VA_{LB}$, un deuxième réseau résonant accordable $RRA2_{LB}$ est connecté à la grille de l'amplificateur auxiliaire $AA_{LB}$ et configuré pour introduire un deuxième déphasage prédéfini $\Phi_a$ au signal RF. A cet effet, le deuxième réseau résonant accordable $RRA2_{LB}$ comprend un condensateur variable $C_{sa2}$ mis en série avec une inductance $L_{sa2}$. Un condensateur $C_{pa2}$ est connecté entre un point intermédiaire situé entre le condensateur variable $C_{sa2}$ et l'inductance $L_{sa2}$, et la masse.

Selon un mode de réalisation particulièrement avantageux, le deuxième réseau résonant accordable $RRA2_{LB}$ de la voie d'amplification bande basse $VA_{LB}$ ne comprend pas d'inductance connectée entre le noeud B2 et la masse. Le deuxième réseau résonant accordable $RRA2_{LB}$ de la voie d'amplification bande basse $VA_{LB}$ comprend ainsi une inductance (ou bobine) en moins que le deuxième réseau résonant accordable $RRA2_{HB}$ de la voie d'amplification bande haute $VA_{HB}$.

En effet, le commutateur SW n'offre pas une isolation parfaite entre la voie d'amplification bande haute $VA_{HB}$ et la voie d'amplification bande basse $VA_{LB}$. Lorsque la voie d'amplification bande basse $VA_{LB}$ est activée, le réseau intermédiaire d'adaptation d'impédance ISMN2 est capable de former le niveau d'impédance et de phase requis en tenant compte des parasites du chemin inactif (c'est-à-dire de la voie d'amplification bande haute $VA_{HB}$). Les condensateurs variables des voies d'amplification et les tensions de polarisation des transistors peuvent être également ajustés de façon à ce que les performances soient optimisées en fonction de la fréquence visée. La résistance $R_{div2}$ du troisième circuit résonnant RC3 peut être une résistance variable, ce qui permet d'ajuster les niveaux d'amplitude et de phase requis en tenant compte des parasites du chemin inactif.

Ainsi, l'impédance parasite de la voie d'amplification bande haute $VA_{HB}$ permet de se passer d'une inductance volumineuse supplémentaire dans le deuxième réseau résonant accordable $RRA2_{LB}$ de la voie d'amplification bande basse $VA_{LB}$.

Cela est particulièrement avantageux pour une utilisation de l'amplificateur Doherty dans des applications contraintes en taille telles que les téléphones mobiles, objets connectés ou points d'accès de petite taille (« small cells »).

Dans la voie d'amplification bande haute $VA_{HB}$ et dans la voie d'amplification bande basse $VA_{LB}$, la valeur du premier déphasage $\Phi_m$ et la valeur du deuxième déphasage $\Phi_a$ sont déterminées de façon à ce que leur différence ait une valeur prédéfinie dans la région de back-off de l'amplificateur principal ($AP_{HB}$, $AP_{LB}$) et de l'amplificateur auxiliaire ($AA_{HB}$, $AA_{LB}$).

La différence de phase $\Phi_{diff} = \Phi_m - \Phi_a$ est optimisée pour assurer une modulation de charge et une combinaison de puissance optimales, au niveau du noeud A, dans la région de back-off ($\Phi_{diff}$ sensiblement égale à 90° en théorie). A une fréquence donnée, la différence $\Phi_{diff}$ dépend de la puissance en raison de la non-linéarité des impédances d'entrée de l'amplificateur principal et de l'amplificateur auxiliaire. Ces impédances d'entrée, ainsi que la fonction de transfert des réseaux intermédiaires d'adaptation d'impédance, varient en fonction de la fréquence. Ces effets induisent une variation de $\Phi_{diff}$ et dégradent les performances de l'amplificateur Doherty. Pour éviter une telle dégradation, $\Phi_{diff}$ est optimisé et réajustée dans la zone de back-off (valeur typique de back-off de 4 à 8 dB pour les applications mobiles).

Dans chacune des voies d'amplification, les impédances en bande de base au niveau de la grille et du drain de l'amplificateur principal et de l'amplificateur auxiliaire introduisent un effet mémoire et provoquent une dégradation des performances de linéarité. Pour atténuer cet effet, l'amplificateur principal et l'amplificateur auxiliaire sont polarisés via un résonateur LC parallèle ($L_{tank11}$-$C_{tank11}$, $L_{tank12}$-$C_{tank12}$, $L_{tank21}$-$C_{tank21}$, $L_{tank22}$-$C_{tank22}$,) relié à la grille des transistors.

Selon un mode de réalisation, l'étage de pré-amplification PRA (ou « driver » selon la terminologie anglo-saxonne) comprend deux étages connectés en cascade, avec un premier étage amplificateur DRV1 et un deuxième étage amplificateur DRV2 (connecté à une source d'alimentation externe par l'intermédiaire d'une inductance $L_{supd}$), afin de maintenir un gain en puissance élevé (typiquement de l'ordre de 30dB) pour toutes les fréquences de fonctionnement en bandes haute et basse (un gain en puissance de 30 dB ou supérieur peut être obtenu avec deux étages de pré-amplification, contre moins de 30 dB avec un seul étage de pré-amplification). En effet, lorsque la voie d'amplification bande haute $VA_{HB}$ est activée, le gain en puissance peut être réduit, en raison des caractéristiques intrinsèques de gain des transistors (pour une puissance de sortie et donc une taille de transistor données).

Le deuxième amplificateur DRV2 est connecté directement au réseau intermédiaire d'adaptation d'impédance ISMN2, en particulier au condensateur $C_{CD}$ du réseau commun RCO.

Le premier amplificateur DRV1 et/ou le deuxième amplificateur DRV2 comprennent avantageusement un transistor en grille commune (T11, T12) et un transistor en source commune (T21, T22), selon un montage de type cascode. Cette topologie permet de maximiser le gain global de l'amplificateur Doherty.

Dans le premier étage DRV1 et dans le deuxième étage DRV2, un transistor MOS (par exemple de type body-contact BC-MOS en technologie SOI) peut être utilisée pour le transistor de source commune (T21 et T22), et un transistor LDMOS peut être utilisée pour le transistor de grille commune (T11 et T12). Ce mode de réalisation n'est toutefois pas exclusif, et il peut être envisagé d'utiliser le transistor LDMOS pour tous les transistors de l'étage de pré-amplification PRA.

Il est également possible d'envisager d'autres types de transistors ou combinaisons de transistors.

L'étage de pré-amplification PRA comprend également un réseau d'adaptation d'impédance d'entrée IMN configuré pour adapter l'impédance d'entrée du premier étage DRV1 à une valeur d'impédance de source prédéfinie (classiquement 50 Ohm). Pour cela, un condensateur C10, relié au port d'entrée PE, est connecté à la grille de la source commune T21 par l'intermédiaire d'un condensateur C15. Une inductance L11 est connectée entre un point intermédiaire situé entre les deux condensateurs, et la masse. La grille de la source commune T21 est polarisée par l'intermédiaire d'une résistance R14. La grille commune T11 est polarisée par l'intermédiaire d'une résistance R12. Un condensateur C13 est connecté entre la résistance R12 et la masse.

De façon analogue, l'étage de pré-amplification PRA comprend un deuxième réseau d'adaptation d'impédance ISMN1 connecté entre le premier étage DRV1 et le deuxième étage DRV2 (inductances L16 et $L_{p2}$, résistance R19, et condensateurs C17 et C18, connectés de façon similaire aux composants du réseau d'adaptation d'impédance d'entrée IMN).

Le deuxième réseau d'adaptation d'impédance ISMN1 peut comprendre un filtre de second harmonique PSH, connecté entre la grille de la source commune T22 et la masse. Le filtre de second harmonique PSH comprend une inductance $L_{H2i}$ en série avec un condensateur $C_{H2i}$, qui peut être réglable afin de contrôler l'impédance de second harmonique par rapport à la fréquence porteuse.

Le fait de connecter en cascade le premier amplificateur DRV1 et le deuxième amplificateur DRV2 peut entraîner des instabilités. Afin de garantir une stabilité du premier étage DRV1, un circuit de rétroaction CRE comprenant un condensateur C21 et une résistance variable R20 en série est connecté entre le drain du transistor monté en grille commune T11 et la grille du transistor monté en source commune T21.

Le réglage de la valeur de la résistance variable R20 est effectué en fonction de la voie d'amplification sélectionnée.

Selon un mode de réalisation de l'invention, il est également possible de n'utiliser qu'un seul étage amplificateur DRV, comme l'illustre la figure 2c.

Selon un mode de réalisation (en technologie SOI), chacun des condensateurs variables utilisés dans l'amplificateur Doherty est composé d'un condensateur à valeur fixe, d'un ensemble de condensateurs à réglage grossier et d'un ensemble de condensateurs à réglage fin, connectés en parallèle. L'ensemble de condensateurs à réglage grossier et l'ensemble de condensateurs à réglage fin est constitué de plusieurs branches de condensateurs variables, chaque condensateur étant connecté à un empilement de transistors afin de pondérer la valeur du réglage grossier ou du réglage fin.

Le facteur de qualité (Q) du condensateur variable définit la plage de réglage TR (rapport entre valeur maximale et minimale de capacité), et la valeur de tension aux bornes du condensateur détermine le nombre de transistors empilés (N) ainsi que la largeur de grille des transistors (Wg). Plusieurs transistors sont empilés pour supporter le niveau maximum de tension à l'état OFF.

Il existe d'autres façons de réaliser les condensateurs variables en fonction de la technologie d'intégration considérée (technologies RF-MEMS ou BST par exemple)

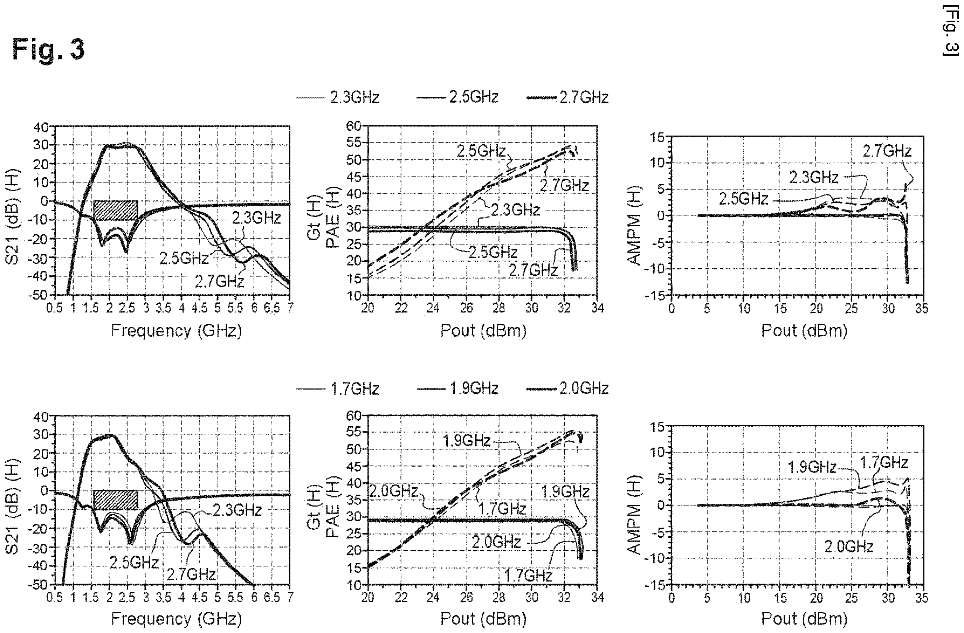

La figure 3 illustre les performances simulées de l'amplificateur Doherty conforme à l'invention, pour différentes fréquences de fonctionnement. La colonne de gauche représente le paramètre de transmission entrée-sortie S21 (gain en puissance, en dB) et d'adaptation en entrée S11 en fonction de la fréquence de fonctionnement. La colonne du milieu représente le rendement en puissance ajoutée PAE (pour « Power Added Efficiency »), en pourcents, en fonction de la puissance de sortie $P_{out}$ (en dBm). La colonne de droite représente les caractéristiques de linéarité AM/AM (modulation d'amplitude à modulation d'amplitude) et AM/PM (modulation d'amplitude à modulation de phase).

D'après les simulations du rendement en puissance ajoutée PAE, l'amplificateur Doherty permet de maintenir une efficacité élevée, et d'après les courbes des caractéristiques AM/AM et AM/PM, une très bonne linéarité est obtenue sur la plage de fréquences 1,7-2,7 GHz.

Les performances de l'amplificateur Doherty conforme à l'invention peuvent également être caractérisées en utilisant un facteur de mérite FOM défini par la relation suivante :

$$FOM = PAE + |ACLR|$$

ACLR (pour « Adjacent Channel Leakage power Ratio ») est défini comme le rapport de la puissance moyenne filtrée centrée sur la fréquence de canal attribuée à la puissance moyenne filtrée centrée sur une fréquence de canal adjacent.

Le rendement en puissance ajoutée PAE permet de bien caractériser l'efficacité énergétique, tandis que le rapport de la puissance moyenne filtrée ACLR permet de bien caractériser la linéarité en présence d'un signal de transmission modulé en amplitude et phase.

Le tableau suivant illustre également les très bonnes performances en efficacité et en linéarité de l'amplificateur Doherty conforme à l'invention (ACLR mesuré pour le standard de communication sans fil LTE, E-UTRA pour « Evolved Universal Terrestrial Radio Access ») :

| Paramètre | Bande basse | | | Bande haute Unité | | | |
|---|---|---|---|---|---|---|---|
| Fréq. | 1,7 | 1,8 | 2,0 | 2,3 | 2,5 | 2,7 | GHz |
| Pout | 28 | | | | | | dBm |
| PAE | 40 | 42,1 | 42,8 | 42,8 | 42,7 | 41,2 | % |
| ACLR | -37,7 | -36,6 | -34,8 | -35,7 | -38 | -33,8 | dBc |
| FOM | 77,7 | 78,7 | 77,6 | 78,5 | 80,6 | 75 | |

Ainsi, l'amplificateur Doherty permet d'obtenir un facteur de mérite FOM supérieur à 75 sur toute la bande 1,7-2,7 GHz en fournissant une puissance de sortie $P_{out}$ égale à 28 dBm, sans utiliser de prédistorsion numérique.

**Références citées :**

[1] RF Power Amplifiers for Wireless Communications, Second Edition, Steve C. Cripps, Artech House, pp. 290-298

[2] P. Draxler and J. Hur, « A multi-band CMOS Doherty PA with tunable matching network », 2017 IEEE MTT-S International Microwave Symposium (IMS), Honolulu, HI, USA, Jun. 2017, pp. 944 -946. doi: 10.1109/MWSYM.2017.8058742

[3] A. Serhan et al., « A Reconfigurable SOI CMOS Doherty Power Amplifier Module for Broadband LTE High -Power User Equipment Applications », 2020 IEEE Radio Frequency Integrated Circuits Symposium (RFIC), Los Angeles, CA, USA, Aug. 2020, pp. 79-82. doi: 10.1109/RFIC49505.2020.9218305

[4] J. Bachi et al., « A Novel Approach for Doherty PA Design Using a Compact L-C Combiner », in IEEE Transactions

**EP 4 489 301 A1**

on Circuits and Systems II: Express Briefs, vol. 69, no. 10, pp. 4023-4027, Oct. 2022, doi: 10.1109/TCSII.2022.3185174

**Revendications**

1. Amplificateur Doherty comprenant :

   - un port d'entrée (PE), configuré pour recevoir un signal RF d'entrée (RF$_{IN}$) à amplifier ;
   - un étage de pré-amplification (PRA) configuré pour amplifier le signal RF d'entrée (RF$_{IN}$) ;
   - au moins un port de sortie (PS1, PS2) configuré pour fournir un signal RF amplifié ; **caractérisé en ce que** l'amplificateur Doherty comprend en outre :
   - une voie d'amplification bande haute (VA$_{HB}$), adaptée pour amplifier le signal RF d'entrée (RF$_{IN}$) dont la bande de fréquence de fonctionnement se trouve dans une bande de fréquences dite supérieure ;
   - une voie d'amplification bande basse (VA$_{LB}$), adaptée pour amplifier le signal RF d'entrée (RF$_{IN}$) dont la bande de fréquence de fonctionnement se trouve dans une bande de fréquences dite inférieure ;
   la voie d'amplification bande haute (VA$_{HB}$) et la voie d'amplification bande basse (VA$_{LB}$) comprenant chacune un amplificateur principal (AP$_{HB}$, AP$_{LB}$), un amplificateur auxiliaire (AA$_{HB}$, AA$_{LB}$), et un réseau d'adaptation d'impédance de sortie (OMN$_{HB}$, OMN$_{LB}$) connecté à l'amplificateur principal (AP$_{HB}$, AP$_{LB}$), à l'amplificateur auxiliaire (AA$_{HB}$, AA$_{LB}$), et au port de sortie (PS1, PS2) ;
   - un réseau intermédiaire d'adaptation d'impédance (ISMN2), connecté entre l'étage de pré-amplification (PRA) et chacun des amplificateurs principaux (AP$_{HB}$, AP$_{LB}$) et auxiliaires (AA$_{HB}$, AA$_{LB}$), le réseau intermédiaire d'adaptation d'impédance (ISMN2) comprenant un réseau commun (RCO) équipé d'un commutateur (SW) configuré pour activer sélectivement la voie d'amplification bande haute (VA$_{HB}$) ou la voie d'amplification bande basse (VA$_{LB}$), le commutateur (SW) comprenant une borne d'entrée (BE) connectée à l'étage de pré-amplification (PRA), une borne de sortie (BS1) connectée à la voie d'amplification bande haute (VA$_{HB}$), et une borne de sortie (BS2) connectée à la voie d'amplification bande basse (VA$_{LB}$).

2. Amplificateur selon la revendication 1, dans lequel, dans chacune des voies d'amplification bande haute (VA$_{HB}$) et bande basse (VA$_{LB}$), le réseau intermédiaire d'adaptation d'impédance (ISMN2) comprend un premier réseau résonant accordable (RRA1$_{HB}$, RRA1$_{LB}$) connecté à la grille de l'amplificateur principal (AP$_{HB}$, AP$_{LB}$) et configuré pour introduire un premier déphasage prédéfini ($\Phi_m$), et un deuxième réseau résonant accordable (RRA2$_{HB}$, RRA2$_{LB}$) connecté à la grille de l'amplificateur auxiliaire (AA$_{HB}$, AA$_{LB}$) et configuré pour introduire un deuxième déphasage prédéfini ($\Phi_a$), la valeur du premier déphasage et la valeur du deuxième déphasage étant déterminées de façon à ce que leur différence ($\Phi_{diff}$) ait une valeur prédéfinie dans la région de back-off de l'amplificateur Doherty, le deuxième réseau résonant accordable (RRA2$_{HB}$) de la voie d'amplification bande haute (VA$_{HB}$) comprenant une inductance supplémentaire (L$_{pa1}$) par rapport au deuxième réseau résonant accordable (RRA2$_{LB}$) de la voie d'amplification bande basse (VA$_{LB}$).

3. Amplificateur selon la revendication 2, dans lequel la différence ($\Phi_{diff}$) est optimisée pour maximiser l'efficacité et la linéarité globale de l'amplificateur.

4. Amplificateur selon la revendication 3, dans lequel la différence ($\Phi_{diff}$) est égale à 90°.

5. Amplificateur selon l'une des revendications 2 à 4, dans lequel le premier réseau résonant accordable (RRA1$_{HB}$, RRA1$_{LB}$) et le deuxième réseau résonant accordable (RRA2$_{HB}$, RRA2$_{LB}$) comprennent des condensateurs variables.

6. Amplificateur selon la revendication 5, dans lequel chaque condensateur variable comprend un condensateur à capacité fixe, un ensemble de condensateurs à réglage grossier et d'un ensemble de condensateurs à réglage fin, l'ensemble de condensateurs à réglage grossier et l'ensemble de condensateurs à réglage fin étant constitué de plusieurs branches de condensateurs, chaque condensateur étant connecté à un empilement de transistors afin de pondérer respectivement la valeur du réglage grossier ou du réglage fin.

7. Amplificateur selon l'une des revendications précédentes, dans lequel le réseau intermédiaire d'adaptation d'impédance (ISMN2) comprend un diviseur de puissance composé d'un premier circuit résonant (LC1) disposé dans le réseau commun (RCO), d'un deuxième circuit résonant (RC2) disposé dans la voie d'amplification bande haute (VA$_{HB}$), et d'un troisième circuit résonant (RC3) disposé dans la voie d'amplification bande basse (VA$_{LB}$).

8

8. Amplificateur selon la revendication 7, dans lequel le troisième circuit résonant (RC3) comprend une résistance variable ($R_{div2}$).

9. Amplificateur selon l'une des revendications précédentes, dans lequel l'étage de pré-amplification (PRA) comprend :

- un premier étage (DRV1) ;
- un réseau d'adaptation d'impédance d'entrée (IMN) configuré pour adapter l'impédance d'entrée du premier étage (DRV1) à une valeur prédéfinie ;
- un deuxième étage (DRV2) connecté directement au réseau intermédiaire d'adaptation d'impédance (ISMN2) ;
- un deuxième réseau d'adaptation d'impédance d'entrée (ISMN1) connecté entre le premier étage (DRV1) et le deuxième étage (DRV2).

10. Amplificateur selon la revendication 9, dans lequel le deuxième réseau d'adaptation d'impédance d'entrée (ISMN1) comprend un filtre de second harmonique (PSH).

11. Amplificateur selon l'une des revendications 9 ou 10, dans lequel le premier étage (DRV1) et/ou le deuxième étage (DRV2) comprennent un montage en grille commune (T11, T12) et un montage en source commune (T21, T22), selon un montage de type cascode.

12. Amplificateur selon la revendication 11, dans lequel un circuit de rétroaction (CRE), comprenant un condensateur (C21) et une résistance variable (R20), est connecté entre le drain du transistor monté en grille commune (T11) et la grille du transistor monté en source commune(T21) dans le premier étage (DRV1), la valeur de la résistance variable (R20) étant réglée en fonction de la voie d'amplification activée.

13. Amplificateur selon l'une des revendications précédentes, dans lequel l'amplificateur principal ($AP_{HB}$, $AP_{LB}$) et l'amplificateur auxiliaire ($AA_{HB}$, $AA_{LB}$) de la voie d'amplification bande haute ($VA_{HB}$) et de la voie d'amplification bande basse ($VA_{LB}$) comprennent des transistors de type LDMOS.

14. Amplificateur selon l'une des revendications précédentes, dans lequel le réseau d'adaptation de sortie de la voie d'amplification bande haute ($OMN_{HB}$) et le réseau d'adaptation de sortie de la voie d'amplification bande basse ($OMN_{LB}$) comprennent chacun un combineur de sortie, connecté directement à l'amplificateur principal ($AP_{HB}$, $AP_{LB}$) et à l'amplificateur auxiliaire ($AA_{HB}$, $AA_{LB}$).

15. Amplificateur selon la revendication 14, dans lequel le combineur de sortie comprend un inverseur d'impédance.

[Fig. 1]

# Fig. 1

[Fig. 2a]

# Fig. 2a

[Fig. 2b]

# Fig. 2b

[Fig. 2c]

# Fig. 2c

[Fig. 3]

# Fig. 3

EP 4 489 301 A1

Europäisches
Patentamt

European
Patent Office

Office européen
des brevets

# RAPPORT DE RECHERCHE EUROPEENNE

Numéro de la demande

EP 24 18 7200

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 207 968 428 U (WUHAN HONGXIN TELECOMM TECHNO) 12 octobre 2018 (2018-10-12) | 1,9-12, 14,15 | INV. H03F1/02 |
| Y | * alinéa [0002] - alinéa [0004] * <br> * alinéa [0038] - alinéa [0058]; figure 2 * | 2-8,13 | H03F1/56 H03F1/22 H03F3/195 H03F3/24 |
| | ----- | | |
| Y,D | SERHAN A ET AL: "A Reconfigurable SOI CMOS Doherty Power Amplifier Module for Broadband LTE High-Power User Equipment Applications", 2020 IEEE RADIO FREQUENCY INTEGRATED CIRCUITS SYMPOSIUM (RFIC), IEEE, 4 août 2020 (2020-08-04), pages 79-82, XP033838356, DOI: 10.1109/RFIC49505.2020.9218305 * partie II intitulée: "Proposed Reconfigurable Doherty PA"; page 79 - page 80; figure 2 * | 2-8,13 | H03F3/72 |
| | ----- | | |

DOMAINES TECHNIQUES
RECHERCHES (IPC)

H03F

Le présent rapport a été établi pour toutes les revendications

| Lieu de la recherche | Date d'achèvement de la recherche | Examinateur |
|---|---|---|
| La Haye | 23 août 2024 | Wienema, David |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...................................................................................................
& : membre de la même famille, document correspondant

EPO FORM 1503 03.82 (P04C02)

**EP 4 489 301 A1**

## ANNEXE AU RAPPORT DE RECHERCHE EUROPEENNE
## RELATIF A LA DEMANDE DE BREVET EUROPEEN NO.

EP 24 18 7200

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-08-2024

| Document brevet cité au rapport de recherche | Date de publication | Membre(s) de la famille de brevet(s) | Date de publication |
|---|---|---|---|
| CN 207968428 U | 12-10-2018 | AUCUN | |

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **STEVE C. CRIPPS**. RF Power Amplifiers for Wireless Communications. Artech House, 290-298
- **P. DRAXLER** ; **J. HUR**. A multi-band CMOS Doherty PA with tunable matching network. *2017 IEEE MTT-S International Microwave Symposium (IMS), Honolulu, HI, USA*, June 2017, 944-946
- **A. SERHAN et al.** A Reconfigurable SOI CMOS Doherty Power Amplifier Module for Broadband LTE High -Power User Equipment Applications. *2020 IEEE Radio Frequency Integrated Circuits Symposium (RFIC), Los Angeles, CA, USA*, August 2020, 79-82
- **J. BACHI et al.** A Novel Approach for Doherty PA Design Using a Compact L-C Combiner. *IEEE Transactions on Circuits and Systems II: Express Briefs*, October 2022, vol. 69 (10), 4023-4027